(19)

Europäisches
Patentamt
European
Patent Office
Office européen
des brevets

(11) **EP 2 105 933 A1**

(12) **EUROPEAN PATENT APPLICATION**

(43) Date of publication:
**30.09.2009 Bulletin 2009/40**

(51) Int Cl.:
*G11C 17/16* (2006.01)    *G11C 17/18* (2006.01)

(21) Application number: **09165920.1**

(22) Date of filing: **13.08.2007**

(84) Designated Contracting States:
**DE FR IT**

(30) Priority: **18.08.2006 JP 2006223428**

(62) Document number(s) of the earlier application(s) in
accordance with Art. 76 EPC:
**07114261.6 / 1 895 543**

(71) Applicant: **Fujitsu Microelectronics Limited
Tokyo 163-0722 (JP)**

(72) Inventor: **Yamaguchi, Shusaku
Kanagawa Kanagawa 211-8588 (JP)**

(74) Representative: **Kreutzer, Ulrich
Cabinet Beau de Loménie
Bavariaring 26
80336 München (DE)**

Remarks:
This application was filed on 20-07-2009 as a
divisional application to the application mentioned
under INID code 62.

(54) **Electric fuse circuit and electronic component**

(57)    An electric fuse circuit is provided which has a capacitor (101) that forms an electric fuse; a write circuit (103) for breaking an insulating film of the capacitor (101), by applying a voltage to a terminal of the capacitor in response to a write signal; and at least two transistors, including a first transistor (121) and a second transistor (102), which are connected in series between the capacitor (101) and the write circuit (103).

F I G. 7

**Description**

BACKGROUND OF THE INVENTION

[Field of the Invention]

The present invention relates to an electric fuse circuit and an electronic component.

[Description of the Related Art]

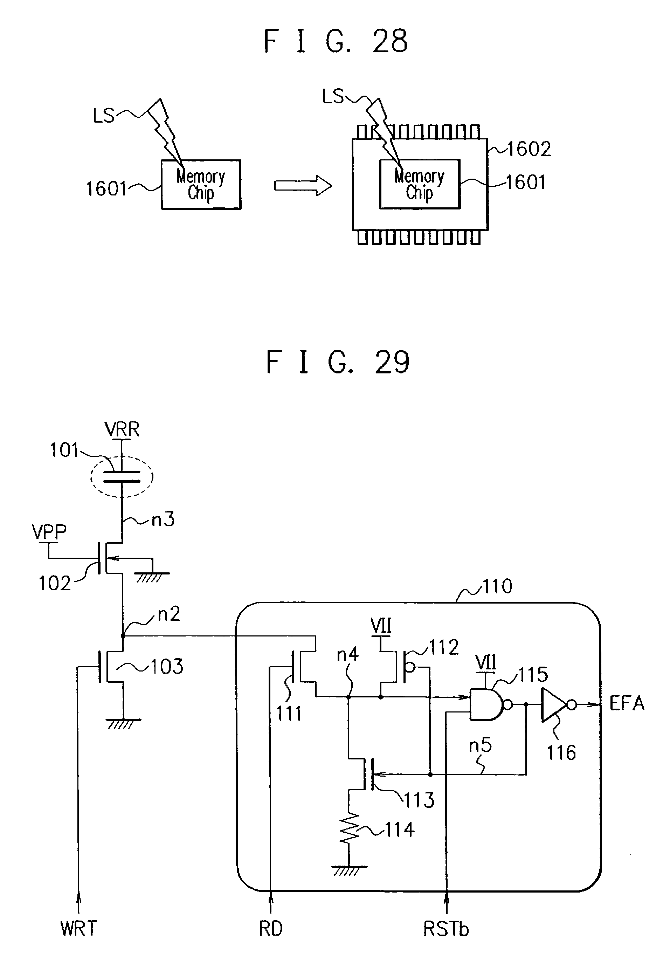

Fig. 28 is a view illustrating a semiconductor memory chip having laser fuses. In a recent semiconductor memory, which has a redundant memory cell utilizing a laser fuse, it is common practice to replace a defective memory cell with the redundant memory cell. A laser fuse is a nonvolatile ROM in which information is written by irradiating a laser beam onto a wiring conductive layer to disconnect the fuse (e.g., when being connected, it is electrically conductive, i.e., "0"; when being disconnected, it is electrically nonconductive, i.e., "1") and the address of the defective memory cell is stored in the ROM so that the redundant memory cell will take over. There is a known phenomenon such as degradation of the refresh characteristics of a DRAM in a memory chip 1601 due to heat or the like produced when it is packaged. However, a laser beam LS cannot be radiated after packaging. Accordingly, a method has been studied in which an electrically writable electric fuse is used as a nonvolatile ROM on which the address of a defective memory cell is stored to accomplish the replacement with a redundant memory cell.

Fig. 29 is a diagram illustrating an exemplary configuration of an electric fuse circuit. Hereinafter, a field-effect transistor is referred to simply as a transistor. An electric-fuse capacitor 101 is connected between a voltage VRR and a node n3. The gate, the drain, and the source of an n-channel transistor 102, which is a protection transistor, are connected to a voltage VPP, the node n3, and a node n2, respectively. The voltage VPP is, for example, 3 V. The gate, the drain, and the source of an n-channel transistor 103, which is a write circuit, are connected to a write signal WRT, the node n2, and the ground, respectively.

Next, the configuration of a read circuit 110 will be explained. The gate, the drain, and the source of an n-channel transistor 111 are connected to a read signal RD, the node n2, and a node n4, respectively. The gate, the drain, and the source of an n-channel transistor 113 are connected to a node n5, the node n4, and the ground via a resistor 114, respectively. The gate, the source, and the drain of a p-channel transistor 112 are connected to the node n5, a voltage VII, and the node n4, respectively. The voltage VII is, for example, 1.6 V. The input terminal and the output terminal of a negative AND (NAND) circuit 115, which is connected to the power-supply voltage VII, are connected to the node n4 and the wire of a signal RSTb, and the node n5, respectively. The input terminal and the output terminal of a negation (NOT) circuit 116 are connected to the node 5 and the wire of a signal EFA, respectively.

In addition, a current cutoff circuit in Japanese Patent Application Laid-Open No. 2002-197889 includes a first field-effect transistor and a second field-effect transistor whose current paths are connected in series to a first fuse and a second fuse, respectively, a pad electrode connected to the gate of the first field-effect transistor, a load resistor connected between a power source and the gate of the first field-effect transistor, and a fuse circuit for determining the conductivity of the second field-effect transistor, in accordance with whether or not a defect should be repaired.

Additionally, in Japanese Patent Application Laid-Open No. 2001-338495, a semiconductor memory device, included in a DRAM-redundant-row decoder, is described in which a plurality of n-channel MOS transistors whose gates each receives a predecoded signal allocated to a corresponding word line are connected in series between respective ones of terminals of corresponding fuses and the ground potential GND.

In recent years, it is known that a leakage current named "a GIDL (Gate Induce Drain Leak) current" exists in a MOS transistor. For example, when the gate voltage of the transistor 102 is 0 V, the drain voltage raised to 4 V (i.e., the electric-potential difference of 4 V or higher between the gate and the drain) causes a leakage current between the drain and the back gate (bulk). Write operation on a plurality of electric fuses is performed one by one by means of a shift register. However, when writing is performed on a given electric fuse after writing on another electric fuse is performed, the gate voltage and the drain voltage of the protection transistor 102 for the written electric fuse circuit becomes VPP, i.e., 3 V and VRR, i.e., 8 V, respectively. The electric-potential difference between the gate and the drain becomes 5 V and a GIDL current is generated. Because of a small current supply capacity (approximately several dozen microamperes) of a voltage-boost pumping circuit, which is provided in the semiconductor chip and generates eight-volt VRR, the occurrence of a GIDL current of several hundreds of microamperes prevents the voltage-boost pumping circuit from generating such a high voltage as 8 V; thus, it has been a problem that writing cannot be properly performed.

In addition, it is known that, after the insulating films have been broken, there is a large variation in the resistance values of electric fuses, and therefore, it is not ensured that there would not be a situation where "even though writing has been completed, a detection circuit cannot determine that the electric fuse is conductive due to an excessive resistance value," and it is a problem that sufficient reliability cannot be achieved.

Additionally, write operation for an electric fuse requires a high voltage such as 8 V to be applied; however, there is a risk that the high voltage breaks the PN junction between the diffusion layer, in which the source-drain region of a MOS transistor is formed, and the well.

In recent years, an SIP (System in Package) and the like are known, in which a memory chip and a logic (processor) chip are mounted on a same package in order to downsize an electronic component; however, when a memory chip is found to be defective in the packaging process, the expensive logic chip mounted on the same package is also regarded as defective, resulting in raised cost.

SUMMARY OF THE INVENTION

The objective of the present invention is to provide a highly-reliable electric fuse circuit and electronic component.

According to an aspect of the present invention, an electric fuse circuit is provided which includes a capacitor that forms an electric fuse; a write circuit for breaking an insulating film of the capacitor, by applying a voltage to a terminal of the capacitor in response to a write signal; and at least two transistors, including a first transistor and a second transistor, which are connected in series between the capacitor and the write circuit.

According to another aspect of the present invention, an electric fuse circuit is provided which includes a first capacitor and a second capacitor for at least two electric fuses and an output circuit for outputting one-bit data, based on resistance of the first and second capacitors.

According to further another aspect of the present invention, an electric component is provided which includes a semiconductor memory chip containing an electric fuse, a semiconductor chip different from the semiconductor memory chip, and a package for packaging both the semiconductor memory chip and the semiconductor chip.

BRIEF DESCRIPTION OF THE DRAWINGS

Fig. 1 is a diagram illustrating an exemplary configuration of an electric fuse circuit according to Embodiment 1 of the present invention;

Fig. 2 is a diagram illustrating an exemplary configuration of an electric fuse circuit according to Embodiment 2 of the present invention;

Fig. 3 is a diagram illustrating an exemplary configuration of an electric fuse circuit according to Embodiment 3 of the present invention;

Fig. 4 is a circuit diagram illustrating an exemplary configuration of a voltage generation circuit according to Embodiment 4 of the present invention;

Fig. 5 is a circuit diagram illustrating an exemplary configuration of a voltage generation circuit according to Embodiment 5 of the present invention;

Fig. 6 is a graph representing a voltage VRRH;

Fig. 7 is a diagram illustrating an exemplary configuration of an electric fuse circuit according to Embodiment 6 of the present invention;

Fig. 8 is a diagram illustrating an exemplary configuration of an electric fuse circuit according to Embodiment 7 of the present invention;

Fig. 9 is a diagram illustrating an exemplary configuration of an electric fuse circuit according to Embodiment 8 of the present invention;

Fig. 10 is a diagram illustrating an exemplary configuration of an electric fuse circuit according to Embodiment 9 of the present invention;

Fig. 11 is a diagram illustrating an exemplary configuration of an electric fuse circuit according to Embodiment 10 of the present invention;

Fig. 12 is a diagram illustrating an exemplary configuration of an electric fuse circuit according to Embodiment 11 of the present invention;

Fig. 13 is a diagram illustrating an exemplary configuration of an electric fuse circuit and the peripheral circuitry thereof according to Embodiment 12 of the present invention;

Fig. 14 is a diagram illustrating an exemplary configuration of an electric fuse circuit and the peripheral circuitry thereof according to Embodiment 13 of the present invention;

Fig. 15 is a timing chart representing an example of write operation for an electric fuse circuit;

Fig. 16 is a diagram illustrating an exemplary configuration of a System in Package (SIP) according to Embodiment 14 of the present invention;

Fig. 17 is a diagram illustrating an example of connection lines between a logic chip and a memory chip;

Fig. 18 is a table representing an example of an electric-fuse operation code outputted from a memory controller in a logic chip to a memory chip;

Fig. 19 is a circuit diagram illustrating an exemplary configuration of an electric fuse control circuit for inputting an electric-fuse operation code in Fig. 18;

Fig. 20 is a timing chart representing the operation of the circuit in Fig. 19;

Fig. 21 is a circuit diagram illustrating an exemplary configuration of an electric fuse control circuit connected to the circuit in Fig. 19;

Fig. 22 is a circuit diagram illustrating an exemplary configuration of an electric fuse control circuit connected to the circuit in Fig. 21;

Fig. 23 is a timing chart representing the operation of the circuit in Fig. 22;

Fig. 24 is a circuit diagram illustrating an exemplary configuration of an electric fuse control circuit connected to the circuit in Fig. 21;

Fig. 25 is a timing chart representing exemplary operation of the circuit in Fig. 24;

Fig. 26 is a flowchart representing an example of processing in which the memory controller in the logic chip in Fig. 16 performs writing in the electric fuse circuit in the memory chip;

Fig. 27 is a diagram illustrating an exemplary configuration of a semiconductor memory chip according to Embodiment 1 of the present invention;

Fig. 28 is a view illustrating a semiconductor memory chip having laser fuses;

Fig. 29 is a diagram illustrating an exemplary configuration of an electric fuse circuit;

Fig. 30 is a diagram illustrating an exemplary configuration of an electric fuse circuit and the peripheral circuitry thereof;

Fig. 31 is a timing chart representing an example of write operation for an electric fuse circuit; and

Fig. 32 is a timing chart, at the time instant when the power source is activated, for a semiconductor memory chip including electric fuse circuits.

DETAILED DESCRIPTION OF THE PREFERRED EMBODIMENTS

(Embodiment 1)

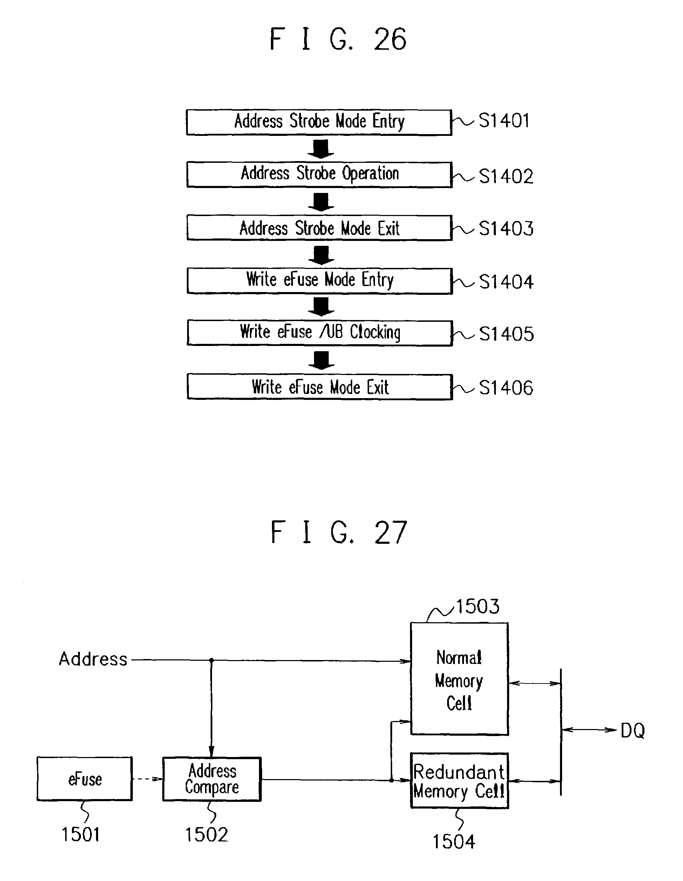

Fig. 27 is a diagram illustrating an exemplary configuration of a semiconductor memory chip according to Embodiment 1 of the present invention. An electric fuse circuit 1501, which is a nonvolatile ROM for storing the address of a defective memory cell in a normal memory cell array 1503, outputs the address of the defective memory cell to an address comparator 1502. The address comparator 1502 compares the address of the defective memory cell with an inputted address and then outputs the result of the comparison of the two addresses to the normal memory cell array 1503 and a redundant memory cell array 1504. In the case where the two addresses do not coincide with each other, the normal memory cell array 1503 reads data DQ from or writes the data DQ in the memory cell corresponding to the inputted address. In the case where the two addresses coincide with each other, the redundant memory cell array 1504 reads data DQ from or writes the data DQ in the memory cell corresponding to the inputted address. As a result, in the case where a defective memory cell exists in the normal memory cell array 1503, the defective memory cell can be replaced by a memory cell in the redundant memory cell array 1504.

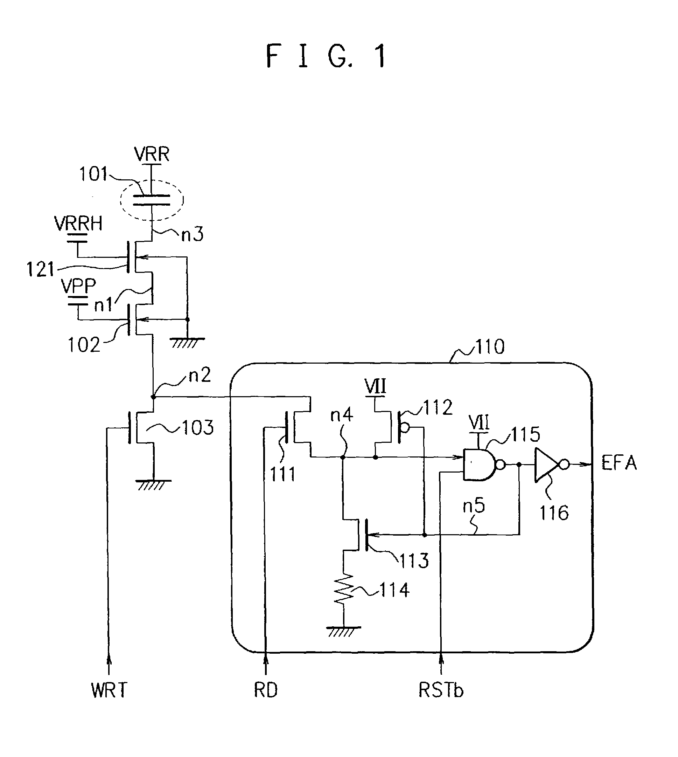

Fig. 1 is a diagram illustrating an exemplary configuration of the electric fuse circuit 1501 according to Embodiment 1. Fig. 1 is a diagram obtained by adding an n-channel field-effect transistor 121 to Fig. 29. Hereinafter, a field-effect transistor is referred to simply as a transistor. A capacitor 101 is connected between a voltage VRR and a node n3 and forms an electric fuse. The gate, the drain, and the source of the n-channel transistor 121, which is a protection transistor, are connected to a voltage VRRH, the node n3, and a node n1, respectively. The voltage VRRH is, for example, 5.5 V. The gate, the drain, and the source of an n-channel transistor 102, which is a protection transistor, are connected to a voltage VPP, the node n1, and a node n2, respectively. The voltage VPP is, for example, 3 V. The gate, the drain, and the source of an n-channel transistor 103, which is a write circuit, are connected to a write signal WRT, the node n2, and the ground (reference electric potential), respectively. The respective back gates (bulks) of the transistors 102 and 121 are connected to the ground.

Next, the configuration of a read circuit 110 will be explained. The gate, the drain, and the source of an n-channel transistor 111 are connected to a read signal RD, the node n2, and a node n4, respectively. The gate, the drain, and the source of an n-channel transistor 113 are connected to a node n5, the node n4, and the ground (reference electric potential) via a resistor 114, respectively. The gate, the source, and the drain of a p-channel transistor 112 are connected to the node n5, a voltage VII, and the node n4, respectively. The voltage VII is, for example, 1.6 V. The input terminal and the output terminal of a negative AND (NAND) circuit 115, which is connected to the power-supply voltage VII, are connected to the node n4 and the wire of a signal RSTb, and the node n5, respectively. The input terminal and the output terminal of a negation (NOT) circuit 116 are connected to the node 5 and the wire of a signal EFA, respectively.

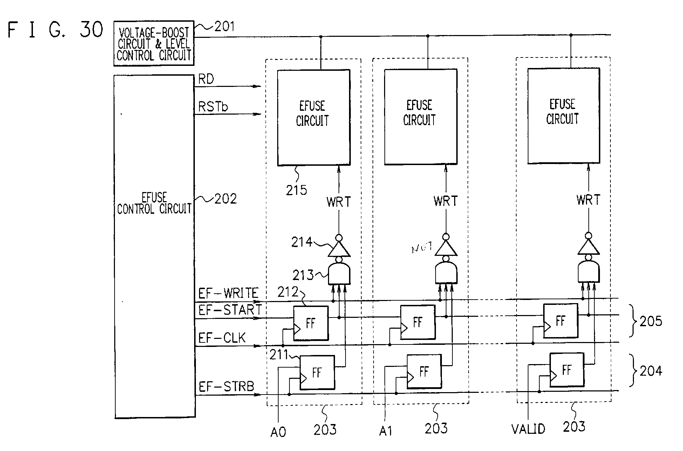

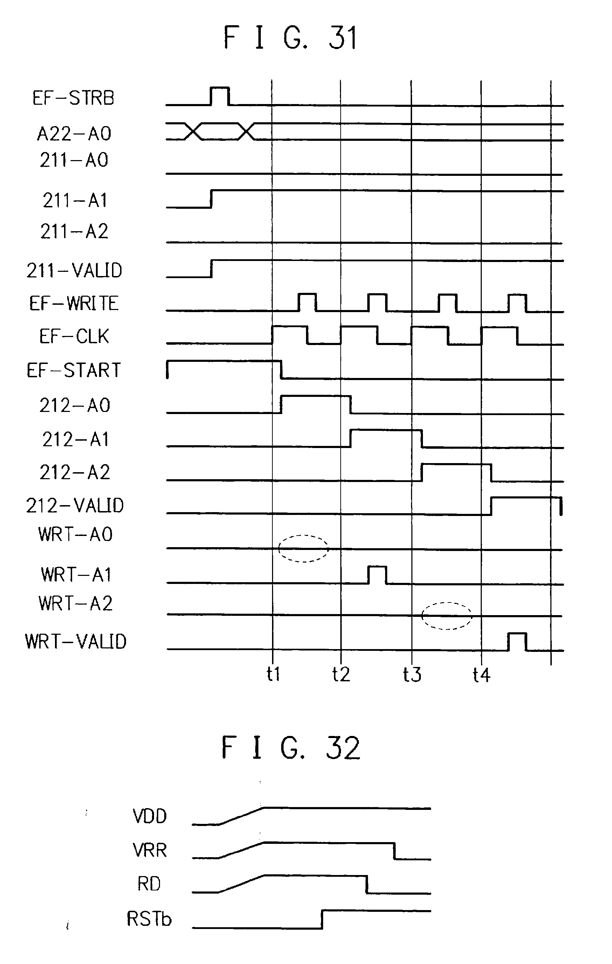

Fig. 30 is a diagram illustrating an exemplary configuration of an electric fuse circuit 215 and the peripheral circuitry therefor; Fig. 31 is a timing chart representing an example of write operation for the electric fuse circuit. The electric fuse circuit 215 corresponds to the electric fuse circuit in Fig. 1. A voltage-boost (pumping) circuit/level control circuit 201, which performs boosting and level control of voltages, supplies a plurality of unit circuits 203 with voltages VRR, VRRH, VPP, VII, and the like. An electric fuse control circuit 202 outputs signals RD, RSTb, EF-WRITE, EF-START, EF-CLK, EF-STRB to the plurality of unit circuits 203. Each of the unit circuits 203 has flip-flops (FFs) 211 and 212, NAND circuit 213, NOT circuit 214, and the electric fuse circuit 215. The respective flip-flops 211 in the plurality of unit circuits 203, which receive the corresponding address signals A0 to A2 or a valid signal VALID, configure an address register 204. For simplicity in explanation, a case with a 3-bit address consisting of address signals A0 to A2 will be explained. The valid signal VALID is a signal indicating whether or not the memory contents in the electric fuses corresponding to the address signals A0 to A2 are validated. For example, in the case where no defective memory cell exists and no replacement with a redundant memory cell is required, the level of the valid signal VALID may be made low. The flip-flops 212 in the plurality of unit circuits 203 configure a shift register 205.

Before the time instant t1, a pulse of the signal EF-STRB is inputted to the respective clock terminals of the flip-flops 211, and the address signals A0 to A2 are inputted to the corresponding input terminals of the flip-flops 211. For example, a case will be explained in which the address signal A0 is low-level, the address signal A1 is high-level, the address signal A2 is low-level, the valid signal VALID is high-level, and those signals are written in the electric fuses. The register 211 for the address signal A0 outputs a low-level signal. The register 211 for the address signal A1 outputs a high-level signal. The register 211 for the address signal A2 outputs a low-level signal. The register 211 for the valid signal VALID outputs a high-level signal.

At and after the time instant t1, a clock signal EF-CLK becomes a clock pulse having a constant frequency. The signal EF-WRITE is a pulse signal having the same period as that of the clock signal EF-CLK. At the time instant t1, the start signal EF-START is made from high-level to low-level. As a result, the shift register 212 shifts the start signal EF-START and then outputs the shifted start signal to the next shift register 212. Accordingly, the register 212 for the address signal A0, the register 212 for the address signal A1, the register 212 for the address signal A2, and the register 212 for the valid signal VALID each output a shifted pulse.

After the time instant t1, the NOT circuit 214 for the address signal A0 keeps the write signal WRT low-level and outputs no pulse. After the time instant t2, the NOT circuit 214 for the address signal A1 outputs a high-level pulse as the write signal WRT. After the time instant t3, the NOT circuit 214 for the address signal A2 keeps the write signal WRT low-level and outputs no pulse. After the time instant t4, the NOT circuit 214 for the valid signal VALID outputs a high-level pulse as the write signal WRT.

In Fig. 1, when the write signal WRT becomes high-level, the transistor 103 turns ON. The high voltage VRR (e.g., 8 V) is applied to the capacitor 101. An electric fuse, which is composed of the capacitor 101, is electrically nonconductive when left as it is. When a high voltage (e.g., 8 V) is applied across the capacitor 101, the insulating film of the capacitor 101 is broken, whereby the capacitor 101 becomes electrically conductive. The two respective states are allocated to "0" and "1". For example, the state, in which the insulating film of the capacitor 101 is not broken and the capacitor 101 is electrically nonconductive, is allocated to "0"; the state, in which the insulating film of the capacitor 101 is broken and the capacitor 101 is electrically conductive, is allocated to "0". The capacitor 101 can be utilized as a nonvolatile ROM.

The high voltage required to perform the operation (hereinafter, referred to as write operation) of breaking the insulating film of the electric fuse is generated by the voltage-boost circuit 201 provided in the semiconductor chip. In addition, when, in performing the write operation, the write operation is concurrently applied to a plurality of capacitors 101, a considerable current may flow; therefore, the shift register 205 is provided so as to apply the write operation one-by-one to the capacitor 101.

The write operation for the capacitor (electric fuse) 101 will be explained. In the first place, the voltage-boost circuit 201 boosts the voltage VRR, which is a voltage at the common node of the plurality of capacitors 101, to a high voltage (e.g., 8 V). On this occasion, the node n3, which is another terminal of the capacitor 101, is floating; thus, the electric potential at the node n3 is also raised. In this situation, the electric-potential difference between both the terminals of the capacitor 101 is still small. After that, the transistor 103 for writing the write signal WRT selected by the shift register 205 is turned ON, thereby making the potential of the node n3 ground-level, and a high voltage is applied across the capacitor 101 so as to break the insulating film of the capacitor 101. At this time, with regard to the capacitor 101 corresponding to the unselected write signal WRT, the node n3 is kept floating, whereby the high voltage is not applied across the unselected capacitor 101.

Fig. 32 is a timing chart, at the time instant when the power source is activated, for a semiconductor memory chip including electric fuse circuits. The voltage VDD, which is a power-source voltage for a semiconductor memory chip, is, for example, 1.8 V. After the power source is activated, the voltages VDD and VRR, and the signal RD are gradually raised. In due course of time, the voltage VRR reaches and remains at approximately 1.6 V. The signal RSTb maintains the low level. In Fig. 1, when the signal RSTb is low-level, the node n5 becomes high-level. Then, the transistor 112 turns OFF, and the transistor 113 turns ON. As a result, the node n4 changes from floating to low-level. After that, the signal RSTb changes from low-level to high-level. When the capacitor 101 is conductive, the node n4 becomes high-level, whereupon the output signal EFA becomes high-level. In contrast, when the capacitor 101 is nonconductive, the node n4 becomes low-level, whereupon the output signal EFA becomes low-level. After that, the voltage VRR and the read signal RD become ground-level, and the transistor 111 turns OFF, whereupon the output signal EFA are maintained at the same level. Based on the foregoing operation, the read circuit 110 outputs, as the signal EFA, the state of the capacitor 101.

In Fig. 30, the write operation for the plurality of electric fuse circuits 215 is performed, with the respective timing instants shifted by the register 205. A case, in which the write operation makes the capacitor 101 in a specific electric fuse circuit 215 nonconductive, will be discussed. Next, when the writing processing for another electric fuse circuit 215 is performed, the voltage VRR becomes 8 V again. In Fig. 1, when the capacitor 101 is conductive, the drain node n3 of the transistor 121 becomes 8 V. The gate voltage VRRH of the transistor 121 is 5.5 V. As discussed above, the electric-potential difference between the gate and the drain becomes 4 V or higher, a GIDL current (leakage current) is caused between the drain and the back gate. The electric-potential difference between the gate and the drain of the transistor 121 is 8 - 5.5 = 2.5 V, whereby the leakage current can be prevented.

In addition, because the gate voltage VRRH of the transistor 121 is 5.5 V, the source node n1 also becomes 5.5 V. Because being connected to the source node n1 of the transistor 121, the drain node n1 of the transistor 102 becomes 5.5 V. The gate voltage VPP of the transistor 102 is 3 V. Thus, the electric-potential difference between the gate and the drain of the transistor 102 is 5.5 - 3 = 2.5 V, whereby the GIDL current can be prevented.

Because the voltage-boost circuit 201, which generates an eight-volt VRR, has a small capability of supplying current (approximately several dozen microamperes), the occurrence of a GIDL current of several hundreds of microamperes makes it impossible for the voltage-boost circuit to generate such a high voltage as 8 V; therefore, normal write operation cannot be performed. According to the present embodiment, the respective GIDL currents of the transistors 102 and 121 can be prevented; therefore, the voltage-boost circuit 201 can generate an eight-volt VRR, whereby normal write operation can be performed.

As described above, the present embodiment includes the capacitor 101 for forming an electric fuse; the write circuit 103 for breaking the insulating film of the capacitor 101, by applying a voltage to a terminal of the capacitor 101 in response to the write signal WRT; and at least two transistors, i.e., the first transistor 121 and the second transistor 102, which are connected in series between the capacitor 101 and the write circuit 103. The first transistor 121 is connected to the capacitor 101 in such a way as to be closer to the capacitor 101 than the second transistor 102. The gate voltage VRRH of the first transistor 121 is higher than the gate voltage VPP of the second transistor 102.

(Embodiment 2)

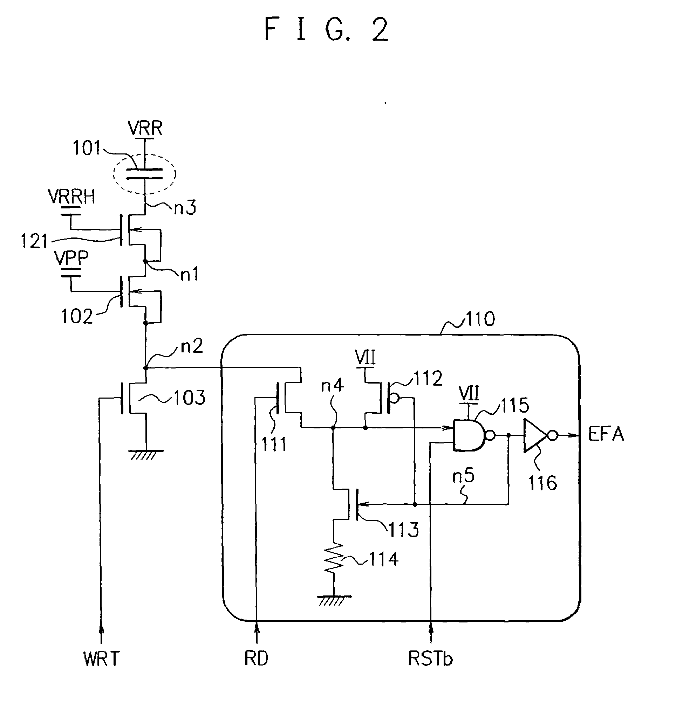

Fig. 2 is a diagram illustrating an exemplary configuration of an electric fuse circuit 1501 according to Embodiment 2 of the present invention. In contrast to Fig. 1, in Fig. 2, the respective back gates of the transistors 102 and 121 are connected to positions different from those in Fig. 1. In Fig. 1, the respective back gates of the transistors 102 and 121 are connected to the ground. Accordingly, when 8 V is applied to the drain node n3 of the transistor 121, the electric-potential difference between the back gate and the drain node n3 is 8 - 0 = 8 V, i.e., a high voltage; thus, the PN junction may be broken.

In the present embodiment (in Fig. 2), the back gate of the transistor 121 is connected to the source node n1. The back gate of the transistor 102 is connected to the source node n2. When, through writing, the capacitor 101 becomes conductive, the drain node n3 of the transistor 121 becomes 8 V. Because the gate voltage VRRH of the transistor 121 is 5.5 V, the source node n1 also becomes 5.5 V. Because being connected to the source node n1, the back gate of the transistor 121 becomes 5.5 V. Thus, the electric-potential difference between the back gate and the drain node n3 of the transistor 121 is 8 - 5.5 = 2.5 V, whereby the breakage of the PN junction can be prevented.

In addition, because being connected to the source node n1 of the transistor 121, the drain node n1 of the transistor 102 becomes 5.5 V. Because the gate voltage VPP of the transistor 102 is 3 V, the source node n2 also becomes 3 V. Because being connected to the source node n2, the back gate of the transistor 102 becomes 3 V. Thus, the electric-potential difference between the back gate and the drain node n1 of the transistor 102 is 5.5 - 3 = 2.5 V, whereby the breakage of the PN junction can be prevented.

(Embodiment 3)

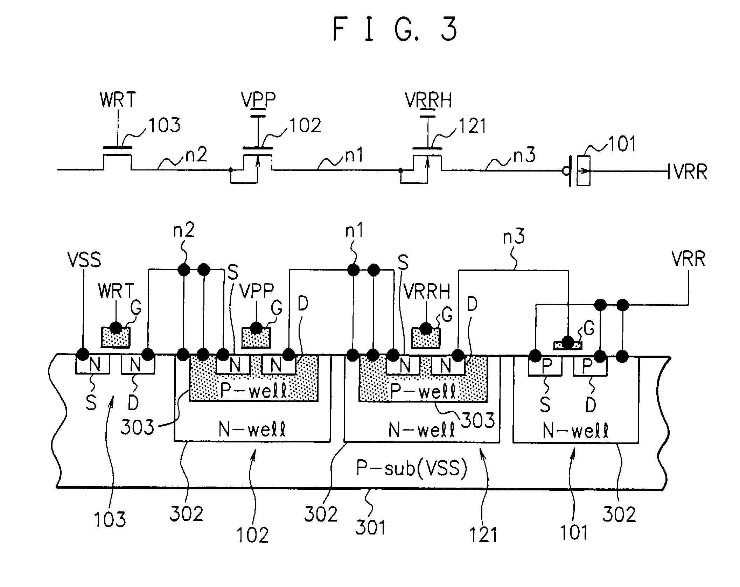

Fig. 3 is a diagram illustrating an exemplary configuration of the electric fuse circuit 1501 according to Embodiment 3 of the present invention. In the present embodiment, the structural examples of the transistors 102, 103, and 121, and the capacitor 101 will be described. In Fig. 3, the upper part illustrates a circuit diagram; the lower part illustrates a vertical cross-sectional view of the semiconductor substrate corresponding to the circuit diagram. The capacitor 101 is composed of a p-channel transistor. The gate of the p-channel transistor 101 is connected to the node n3, and the source, the drain, and the back gate are connected to the voltage VRR.

A p-channel substrate 301 is connected to the reference electric potential (ground) VSS. On the p-channel substrate 301, the transistors 101 to 103 and 121 are formed. The source *S* and the drain *D* of the transistor 103 are n-channel diffusion regions formed in the p-channel substrate 301. The gate <u>G</u>, the source *S*, and the drain *D* of the n-channel transistor 103 are connected to the write signal WRT, the reference electric potential VSS, and the node n2, respectively. In the p-channel substrate 301, three n-channel wells 302 for the corresponding transistors 102, 121, and 101 are formed.

The configuration of the n-channel transistor 102 will be explained. The transistor 102 is provided in the n-channel well 302. A p-channel well 303 is formed in the n-channel well 302. The source *S* and the drain *D* of the transistor 102 are n-channel diffusion regions provided in the p-channel well 303. The n-channel well 302 and the p-channel well 303 are connected to the node n2. The source *S*, the gate, and the drain *D* of the transistor 102 are connected to the node n2, the voltage VPP, and the node n1, respectively.

Next, the configuration of the n-channel transistor 121 will be explained. The transistor 121 is provided in the n-channel well 302. A p-channel well 303 is formed in the n-channel well 302. The source *S* and the drain *D* of the transistor 121 are n-channel diffusion regions provided in the p-channel well 303. The n-channel well 302 and the p-channel well 303 are connected to the node n1. The source *S*, the gate, and the drain *D* of the transistor 121 are connected to the node n1, the voltage VRRH, and the node n3, respectively.

Next, the configuration of the p-channel transistor 101 will be explained. The transistor 101 is provided in the n-channel well 302. The source *S* and the drain *D* of the transistor 101 are p-channel diffusion regions provided in the n-channel well 302. The source *S* and the drain *D*, and the gate of the transistor 101 are connected to the voltage VRR, and the node n3, respectively. The n-channel well 302 is connected to the source *S* and the drain *D*.

As described above, the transistors 102 and 121 each have a triple-well structure, whereby the withstanding-voltage characteristics thereof are superior. The respective gate oxide films (insulating films) of the transistors 102, 103, and 121 are thicker than the gate oxide film (insulating film) of the transistor 101.

(Embodiment 4)

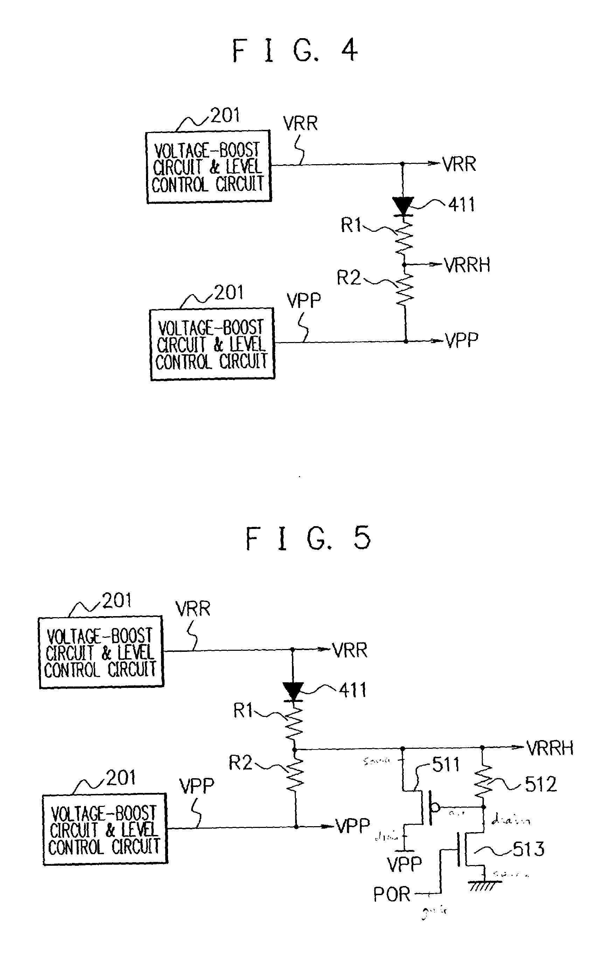

Fig. 4 is a circuit diagram illustrating an exemplary configuration of a voltage generation circuit according to Embodiment 4 of the present invention. The voltage generation circuit can generate the voltage VRRH, based on the voltages VRR and VPP. The respective voltage-boost circuit/level control circuits 201 generate and control the voltages VRR or VPP. The voltage VRR is a voltage ranging from 0 V to 8 V. The voltage VPP is 3 V. The anode and the cathode of a diode 411 whose threshold voltage Vth is, e.g., 0.7 V are connected to the terminal of the voltage VRR and the terminal of the voltage VRRH via a resistor R1, respectively. A resistor R2 is connected between the terminal of voltage VRRH and the terminal of the voltage VPP.

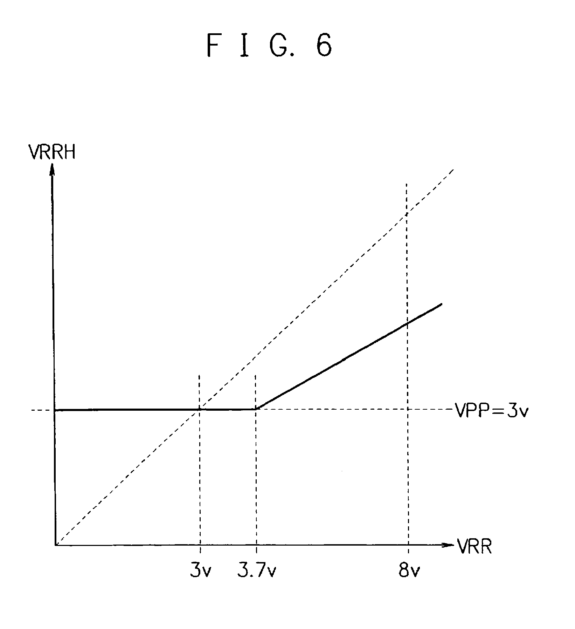

Fig. 6 is a graph representing the voltage VRRH. The abscissa denotes the voltage VRR, and the ordinate denotes the voltage VRRH. The voltage VRR varies from 0 V to 8 V. The voltage VPP is fixed to 3 V. In that case, the voltage VRRH is given by the following equation:

$$\text{VRRH} = (\text{VRR} - \text{Vth}) \times \text{R2}/(\text{R1} + \text{R2}) + \text{VPP} \times \text{R1}/(\text{R1} + \text{R2})$$

As a result, it is possible to set the voltage VRRH to the intermediate potential between the voltage VPP and the voltage VRR; therefore, as is the case with Embodiment 1, the GIDL current can be prevented.

(Embodiment 5)

Fig. 5 is a circuit diagram illustrating an exemplary configuration of a voltage generation circuit according to Embodiment 5 of the present invention; transistors 511 and 513, and a resistor 512 are added to the circuit in Fig. 4. The gate, the source, and the drain of the n-channel transistor 513 are connected to a power-on-reset signal POR, the reference potential, and the terminal of the voltage VRRH via the resistor 512, respectively. The power-on-reset signal POR is a high-level pulse signal that is generated at the time when the power source is activated. The gate, the source, and the drain of the p-channel transistor 511 are connected to the drain of the transistor 513, the voltage VRRH, and the voltage VPP, respectively.

Because the resistor R2 has a large resistance value, the duration from the time instant when the power source is activated to the time instant when the voltage VRRH reaches the voltage VPP is long. Thus, by use of the power-on-reset signal POR, the resistance between the voltage VRRH and the voltage VPP is lowered only when the power source is activated. In other words, when the power source is activated, the power-on-reset signal POR becomes high-level, the transistor 513 turns ON, and the transistor 511 turns ON. As a result, the terminal of the voltage VRRH is connected to the terminal of the voltage VPP via the transistor 511. Thus, when the power source is activated, the voltages VRRH reaches the voltage VPP at high speed. After the power source has been activated, the power-on-reset signal POR becomes low-level, the transistors 513 and 511 turn OFF, and through the same operation as that in Embodiment 4, the voltage VRRH is generated.

(Embodiment 6)

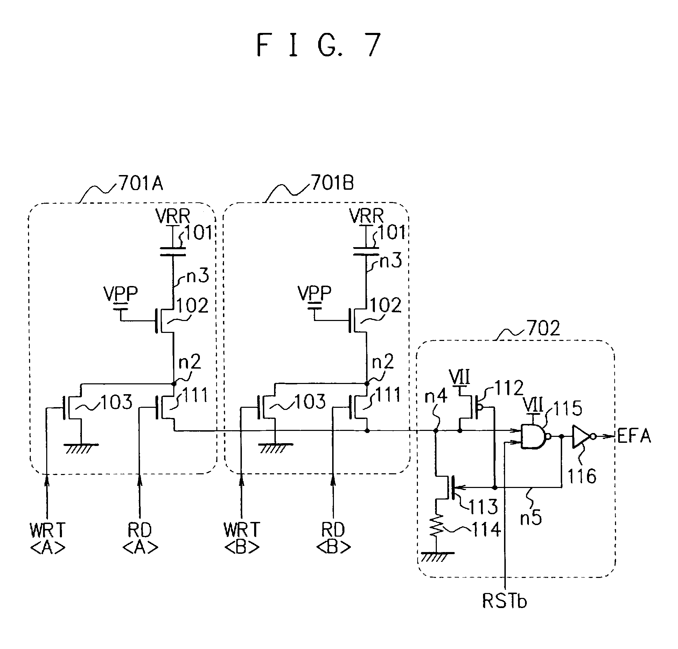

Fig. 7 is a diagram illustrating an exemplary configuration of the electric fuse circuit 1501 according to Embodiment 6 of the present invention. In the present embodiment (in Fig. 7), a pair of circuits 701A and 701B are connected in parallel to the circuit in Fig. 29.

The first circuit 701A and the second circuit 701B each have the same configuration. The configuration of the circuits 701A and 701B will be explained below. The capacitor 101 is connected between the voltage VRR and the node n3. The gate, the drain, and the source of an n-channel transistor 102, which is a protection transistor, are connected to a voltage VPP, the node n3, and the node n2, respectively. The voltage VPP is, for example, 3 V. The gate, the drain, and the source of the n-channel transistor 103, which is a write circuit, are connected to a write signal WRT<A> or WRT<B>, the node n2, and the ground, respectively. The gate, the drain, and the source of the n-channel transistor 111, which is a read circuit, are connected to a read signal RD<A> or RD<B>, the node n2, and the node n4, respectively. In the first circuit 701A, the gate of the transistor 103 is connected to the write signal WRT<A>, and the gate of the transistor 111 is connected to the read signal RD<A>. In the second circuit 701B, the gate of the transistor 103 is connected to the write signal WRT<B>, and the gate of the transistor 111 is connected to the read signal RD<B>. The first circuit 701A and the second circuit 701B are connected in parallel with each other with respect to the node 4.

Next, the configuration of a detection/latch circuit (output circuit) 702 will be explained. The gate, the drain, and the source of the n-channel transistor 113 are connected to the node n5, the node n4, and the ground via the resistor 114, respectively. The gate, the source, and the drain of the p-channel transistor 112 are connected to the node n5, the voltage VII, and the node n4, respectively. The voltage VII is, for example, 1.6 V. The input terminal and the output terminal of the NAND circuit 115, which is connected to the power-supply voltage VII, are connected to the node n4 and the wire of a signal RSTb, and the node n5, respectively. The input terminal and the output terminal of the NOT circuit 116 are connected to the node 5 and the wire of the signal EFA, respectively.

The basic operation is the same as that of Embodiment 1. After its insulating film is broken through write operation, the capacitor 101 becomes conductive. However, when the capacitors 101 are conductive, the resistance values of the respective capacitors 101 in a plurality of electric fuse circuits 215 vary. When the resistance value of the capacitor 101 is low, the signal EFA is outputted as a high-level signal. However, when, even though the insulating film of the capacitor 101 has been broken, the resistance value is relatively high, the signal EFA is outputted as a low-level signal.

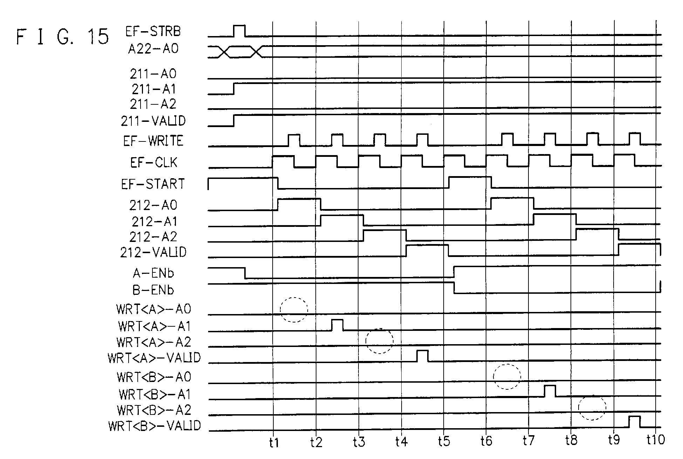

In the present embodiment, the same data is written in the capacitors 101 of the first circuit 701A and the second circuit 701B. That is to say, both the capacitors 101 of the circuits 701A and 701B become conductive or nonconductive. In this regard, however, by staggering the time instants of the write signal WRT<A> and the write signal WRT<B>, the write operation for the first circuit 701A and the second circuit 701B is performed at different time instants. The details of the write operation will be explained later with reference to Fig. 15.

When the data in the capacitor 101 is read, the read signals RD<A> and RD<B> are made high-level at the same time instant. In the case where the respective insulating films of the capacitors 101 in the circuits 701A and 701B are broken through the write operation, the resistance values of the capacitors 101 in the circuits 701A and 701B may vary. In the case where the respective resistance values of the capacitors 101 in the circuits 701A and 701B are small, the node n4 becomes high-level, owing to the circuits 701A and 701B; thus, the signal EFA can correctly be made high-level. Additionally, also in the case where the resistance value of the capacitor 101 in the circuit 701A is small and the resistance value of the capacitor 101 in the circuit 701B is large, the node n4 becomes high-level, owing to the circuit 701A; thus, the signal EFA can correctly be made high-level. Additionally, also in the case where the resistance value of the capacitor 101 in the circuit 701A is large and the resistance value of the capacitor 101 in the circuit 701B is small, the node n4 becomes high-level, owing to the circuit 701B; thus, the signal EFA can correctly be made high-level. As described above, even when the resistance values of the capacitors 101 vary, the signal EFA can correctly be made high-level, as long as the resistance value of at least one of the capacitors 101 in the circuits 701A and 701B is small. Accordingly, the reliability of the electric fuse circuit can be enhanced.

As described above, the present embodiment includes the capacitors 101 of at least two circuits, i.e., the first circuit 701A and the second capacitor 701B, and the output circuit 702 that outputs 1-bit data, based on resistance of the capacitors 101 of the first circuit 701A and the second circuit 701B. If resistance is small in either the capacitors 101 of the first circuit 701A or the second circuit 701B, the output circuit 702 outputs the signal EFA that indicates that that resistance is small. In addition, the output circuit 702 has a single detection circuit that commonly detects the voltage corresponding to the resistance value of the capacitor 101 in the first circuit 701A and the voltage corresponding to the resistance value of the capacitor 101 in the second circuit 701B.

**(Embodiment 7)**

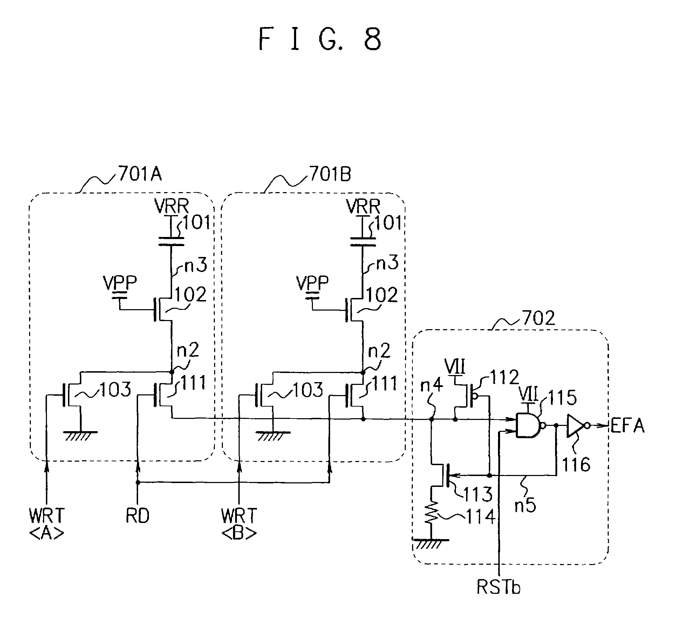

Fig. 8 is a diagram illustrating an exemplary configuration of the electric fuse circuit 1501 according to Embodiment 7 of the present invention. The difference between Embodiments 6 and 7 will be explained. In Fig. 7, the gate of the transistor 111 in the circuit 701A is connected to the read signal RD<A>, and the gate of the transistor 111 in the circuit 701B is connected to the read signal RD<B>. The read signals RD<A> and RD<B> are one and the same. Accordingly, in the present embodiment, the respective gates of the transistors 111 in the circuits 701A and 701B are connected with each other, and the one and the same read signal RD is supplied to the gates. The operation of the present embodiment is the same as that of Embodiment 6.

**(Embodiment 8)**

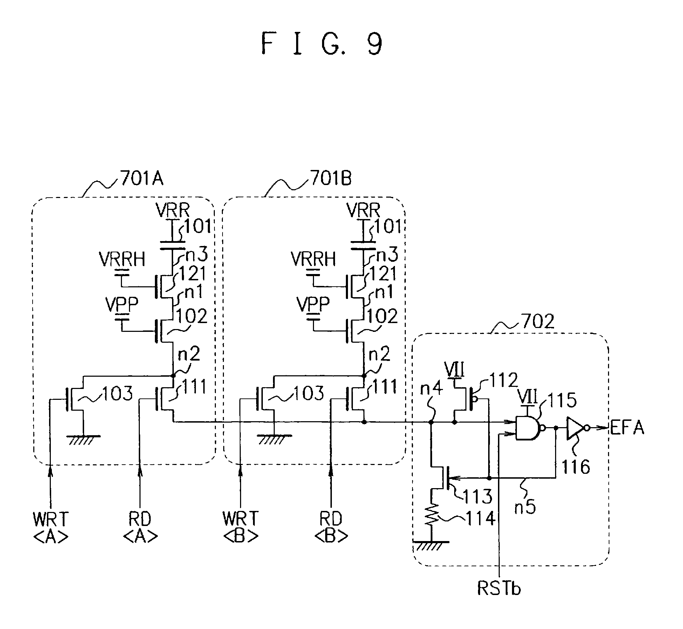

Fig. 9 is a diagram illustrating an exemplary configuration of the electric fuse circuit 1501 according to Embodiment 8 of the present invention. In the present embodiment (in Fig. 9), the transistors 121 are added to the circuit in Fig. 7, as is the case with Embodiment 1. The difference between Embodiments 6 and 8 will be explained below. In circuits 701A and 701B, the gate, the drain, and the source of the n-channel transistor 121 are connected to the voltage VRRH, the node n3, and the node n1, respectively. The capacitor 101 is connected between the voltage VRR and the node n3. The back gate of the transistor 102 is connected to the node n1. The present embodiment demonstrates the respective effects of Embodiments 1 and 6.
As described above, the present embodiment includes at least two transistors, i.e., the first transistor 121 and the second transistor 102 that are connected in series between the capacitors 101 in the first circuit 701A and the write circuit 103, and at least two transistors, i.e., the third transistor 121 and the fourth transistor 102 that are connected in series between the capacitor 101 in the second circuit 701B and the write circuit 103.

**(Embodiment 9)**

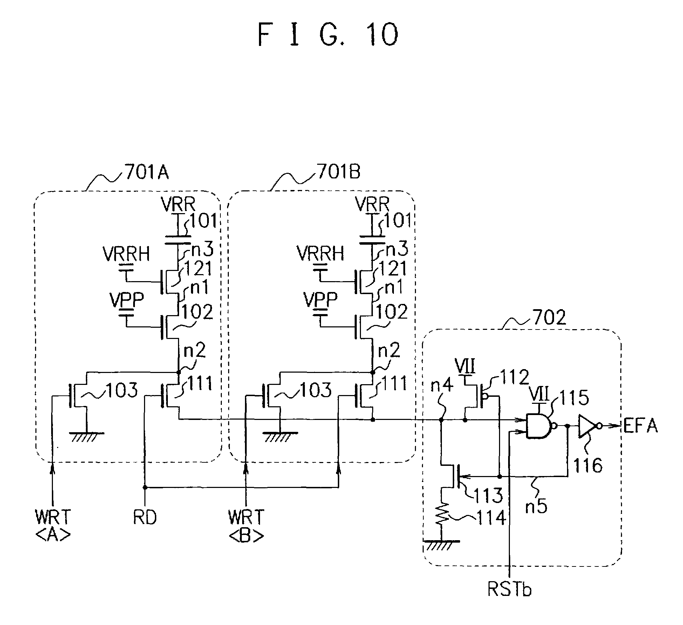

Fig. 10 is a diagram illustrating an exemplary configuration of the electric fuse circuit 1501 according to Embodiment 9 of the present invention. The difference between Embodiments 8 and 9 will be explained. In Fig. 7, the gate of the transistor 111 in the circuit 701A is connected to the read signal RD<A>, and the gate of the transistor 111 in the circuit 701B is connected to the read signal RD<B>. The read signals RD<A> and RD<B> are one and the same. Accordingly, in the present embodiment, as is the case with Embodiment 7, the respective gates of the transistors 111 in the circuits 701A and 701B are connected with each other, and the one and the same read signal RD is supplied to the gates. The operation of the present embodiment is the same as that of Embodiment 8.

**(Embodiment 10)**

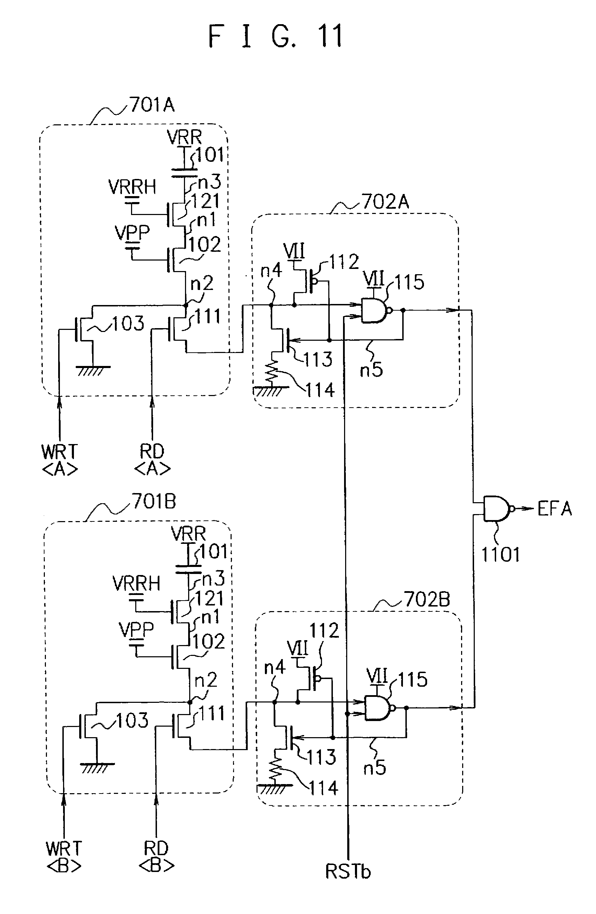

Fig. 11 is a diagram illustrating an exemplary configuration of the electric fuse circuit 1501 according to Embodiment 10 of the present invention. In the present embodiment (in Fig. 11), instead of the detection/latch circuit 702 in Fig. 7, detection/latch circuits 702A and 702B are provided.
In each of the detection/latch circuits 702A and 702B which have the same configuration, the NOT circuit 116 in Fig. 7 is deleted. The configuration of the detection/latch circuits 702A and 702B will be explained below. The gate, the drain, and the source of the n-channel transistor 113 are connected to the node n5, the node n4, and the reference electric potential via the resistor 114, respectively. The gate, the source, and the drain of the p-channel transistor 112 are connected to the node n5, the voltage VII, and the node n4, respectively. The voltage VII is, for example, 1.6 V. The input terminal and the output terminal of the NAND circuit 115, which is connected to the power-supply voltage VII, are connected to the node n4 and the wire of a signal RSTb, and the node n5, respectively.
The input terminal and the output terminal of the NAND circuit 1101 are connected to the respective nodes 5 in the circuits 702A and 702B, and the wire of the signal EFA, respectively.
In Fig. 7, the detection/latch circuit 702 commonly detects and latches the data from the circuits 701A and 701B. In the present embodiment, the detection/latch circuit 702A for the circuit 701A and the detection/latch circuits 702B for the circuit 701B are separately provided. The operation of the present embodiment is the same as that of Embodiment 6.
As described above, the output circuit of the present embodiment has the first detection circuit 702A that detects the voltage corresponding to the resistance value of the capacitor 101 in the first circuit 701A and the second detection circuit 702B that detects the voltage corresponding to the resistance value of the capacitor 101 in the second circuit 701B.

(Embodiment 11)

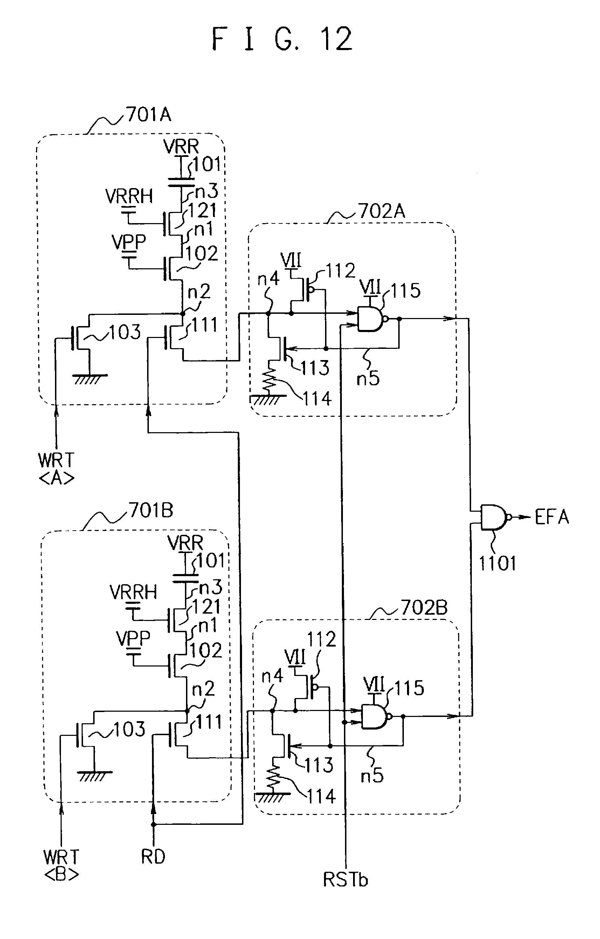

Fig. 12 is a diagram illustrating an exemplary configuration of the electric fuse circuit 1501 according to Embodiment 11 of the present invention. The difference between Embodiments 10 and 11 will be explained. In Fig. 11, the gate of the transistor 111 in the circuit 701A is connected to the read signal RD<A>, and the gate of the transistor 111 in the circuit 701B is connected to the read signal RD<B>. The read signals RD<A> and RD<B> are one and the same. Accordingly, in the present embodiment, as is the case with Embodiment 7, the respective gates of the transistors 111 in the circuits 701A and 701B are connected with each other, and the one and the same read signal RD is supplied to the gates. The operation of the present embodiment is the same as that of Embodiment 10.

(Embodiment 12)

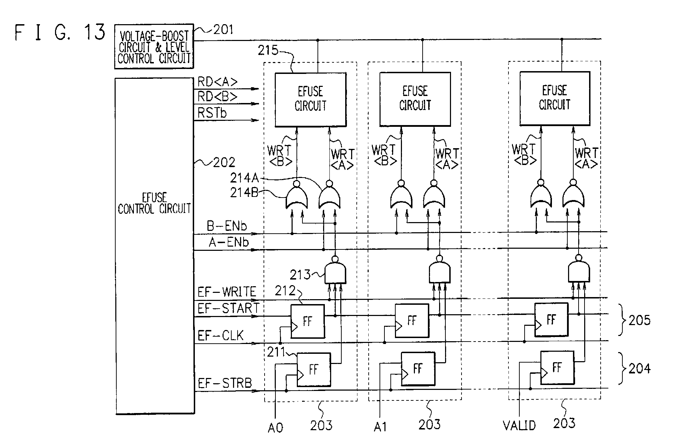

Fig. 13 is a diagram illustrating an exemplary configuration of the electric fuse circuit 215 and the peripheral circuitry thereof according to Embodiment 12 of the present invention; Fig. 15 is a timing chart representing an example of write operation for the electric fuse circuit. The difference between the present embodiment (in Fig. 13) and Embodiment 1 (in Fig. 30) will be explained below. The electric fuse circuit 215 is the electric fuse circuit illustrated in Fig. 7 or Fig. 11. An electric fuse control circuit 202 outputs signals, to a plurality of unit circuits 203, RD<A>, RD<B>, A-ENb, and B-ENb in addition to RSTb, EF-WRITE, EF-START, EF-CLK, and EF-STRB. A negative OR (NOR) circuit 214A outputs, as the write signal WRT<A>, the negative OR signal based on the output signal of the NAND circuit 213 and an enable signal A-ENb to the electric fuse circuit 215. A NOR circuit 214B outputs, as the write signal WRT<B>, the negative OR signal based on the output signal of the NAND circuit 213 and an enable signal B-ENb to the electric fuse circuit 215.

Before the time instant t1, a pulse of the signal EF-STRB is inputted to the respective clock terminals of the flip-flops 211, and the address signals A0 to A2 are inputted to the corresponding input terminals of the flip-flops 211. For example, a case will be explained in which the address signal A0 is low-level, the address signal A1 is high-level, the address signal A2 is low-level, the valid signal VALID is high-level, and those signals are written in the electric fuses. The register 211 for the address signal A0 outputs a low-level signal. The register 211 for the address signal A1 outputs a high-level signal. The register 211 for the address signal A2 outputs a low-level signal. The register 211 for the valid signal VALID outputs a high-level signal. The electric fuse control circuit 202 makes the enable signal A-ENb low-level and the enable signal B-ENb high-level.

At and after the time instant t1, a clock signal EF-CLK becomes a clock pulse having a constant frequency. The signal EF-WRITE is a pulse signal having the same period as that of the clock signal EF-CLK. At the time instant t1, the start signal EF-START is made from high-level to low-level. As a result, the shift register 212 shifts the start signal EF-START and then outputs the shifted start signal to the next shift register 212. Accordingly, the register 212 for the address signal A0, the register 212 for the address signal A1, the register 212 for the address signal A2, and the register 212 for the valid signal VALID each output a shifted pulse.

During the time from t1 to t5, the enable signal B-ENb is high-level, whereby the write signal WRT<B> outputted from the NOR circuit 214B in each of the unit circuits 203 becomes low-level. In contrast, the enable signal A-ENb is low level, whereby the level of the write signal WRT<A> is determined by the address signal and the valid signal.

After the time instant t1, the NOR circuit 214A for the address signal A0 keeps the write signal WRT<A> low-level and outputs no pulse. After the time instant t2, the NOR circuit 214A for the address signal A1 outputs a high-level pulse as the write signal WRT<A>. After the time instant t3, the NOR circuit 214A for the address signal A2 keeps the write signal WRT<A> low-level and outputs no pulse. After the time instant t4, the NOR circuit 214A for the valid signal VALID outputs a high-level pulse as the write signal WRT<A>.

Next, after the time instant t5, the electric fuse control circuit 202 makes the enable signal A-ENb high-level and the enable signal B-ENb low-level.

During the time from t6 to t10, the enable signal A-ENb is high-level, whereby the write signal WRT<A> outputted from the NOR circuit 214A in each of the unit circuits 203 becomes low-level. In contrast, the enable signal B-ENb is low level, whereby the level of the write signal WRT<B> is determined by the address signal and the valid signal.

After the time instant t6, the NOR circuit 214B for the address signal A0 keeps the write signal WRT<B> low-level and outputs no pulse. After the time instant t7, the NOR circuit 214B for the address signal A1 outputs a high-level pulse as the write signal WRT<B>. After the time instant t8, the NOR circuit 214B for the address signal A2 keeps the write signal WRT<B> low-level and outputs no pulse. After the time instant t9, the NOR circuit 214B for the valid signal VALID outputs a high-level pulse as the write signal WRT<B>.

As described above, during the time span from t1 to t5, the writing processing is applied to the capacitor 101 in the first circuit 701A; during a time span, from t6 to t10, which is different from the above time span, the writing processing is applied to the capacitor 101 in the second circuit 701B When the write operation is concurrently applied to the capacitors 101 in the circuits 701A and 701B, a considerable current may flow; therefore, the write operation is applied to the capacitor 101 in the circuit 701A and the capacitor 101 in the circuit 701B at respective timing instants.

In addition, the single electric fuse circuit 215 has the first circuit 701A and the second circuit 701B, and the same address-signal data or the same valid-signal data is written in the first circuit 701A and the second circuit 701B.

As described above, the present embodiment has the write circuit 103 in the first circuit 701A, for breaking the insulating film of the capacitor 101 in the first circuit 701A, by applying a voltage to the terminal of the capacitor 101 in the first circuit 701A in response to the first write signal WRT<A>; and the write circuit 103 in the second circuit 701B, for breaking the insulating film of the capacitor 101 in the second circuit 701B, by applying a voltage to the terminal of the capacitor 101 in the second circuit 701B in response to the second write signal WRT<B>. The respective write circuits 103 in the first circuit 701A and the second circuit 701B apply the voltages to the corresponding capacitors 101 in the first circuit 701A and the second circuit 701B, at the different time instants.

(Embodiment 13)

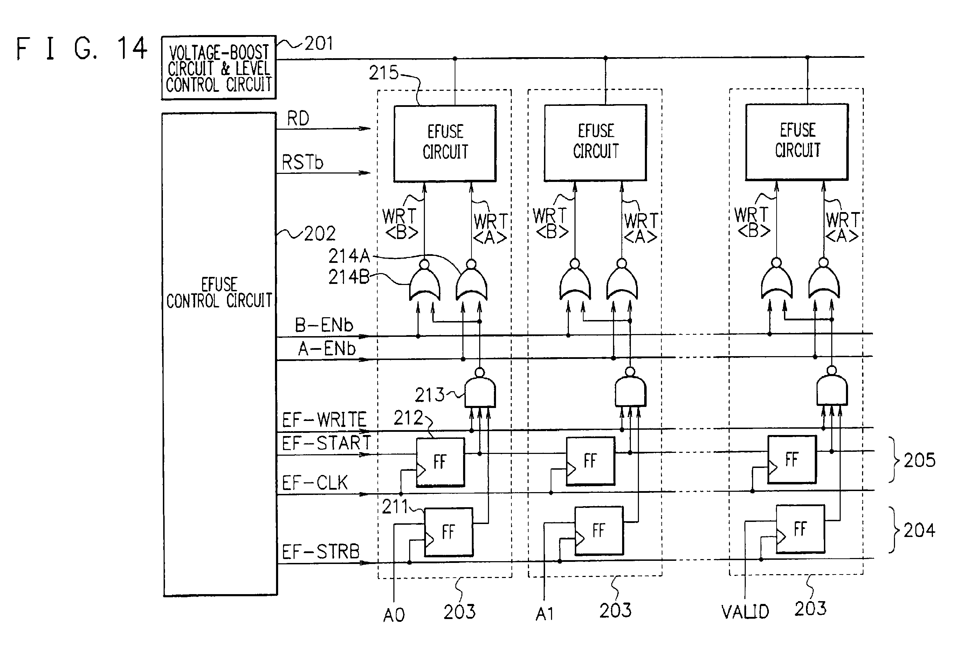

Fig. 14 is a diagram illustrating an exemplary configuration of the electric fuse circuit 215 and the peripheral circuitry thereof according to Embodiment 13 of the present invention. The read signal, i.e., RD of the present embodiment (in Fig. 14) is different from that of Embodiment 12 (in Fig. 13). The difference between Embodiments 12 and 13 will be explained below. The electric fuse circuit 215 is the electric fuse circuit illustrated in Fig. 8 or Fig. 12. An electric fuse control circuit 202 outputs to the plurality of unit circuits 203 the read signals RD, instead of the read signals RD<A> and RD<B>. As illustrated in Fig. 8 or Fig. 12, the read signal RD is inputted to the first circuit 701A and the second circuit 701B.

(Embodiment 14)

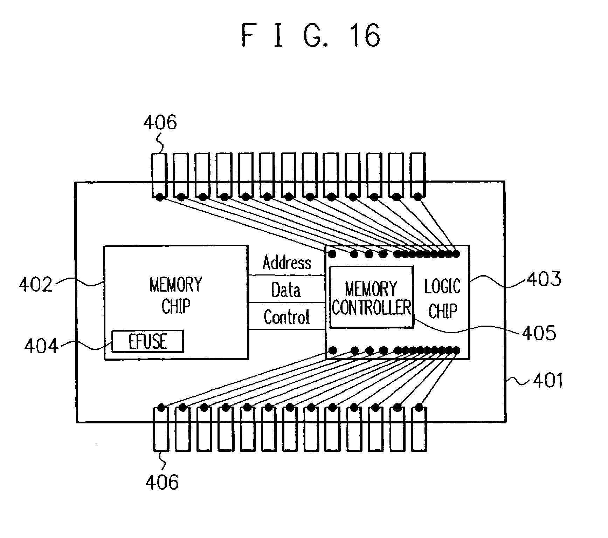

Fig. 16 is a diagram illustrating an example of the configuration of electronic components in a System in Package (SIP) according to Embodiment 14 of the present invention. In a package 401, a memory chip 402 and a logic chip 403 are provided. The memory chip 402 has an electric fuse circuit 404. The memory chip 402 and the electric fuse circuit 404 correspond to the semiconductor memory chip and the electric fuse circuit 1501, respectively, in Fig. 27. The logic chip 403, which has a memory controller 405, is connected to external pins 406. The memory controller 405 controls the memory chip 402, by way of an address line, a data line, and a control line.

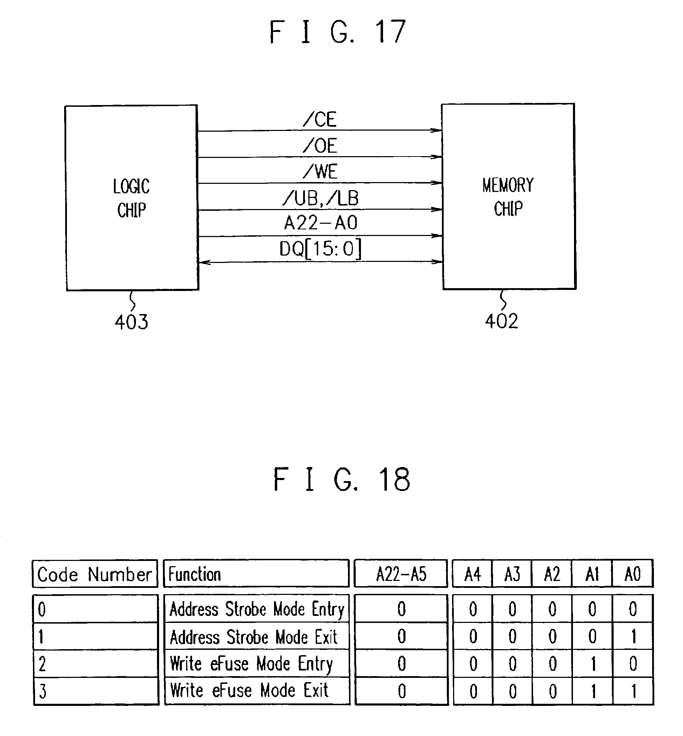

Fig. 17 is a diagram illustrating an example of connection lines between the logic chip 403 and the memory chip 402. The logic chip 403 outputs to the memory chip 402 signals /CE, /OE, /WE, /UB, /LB, and A0 to A22. Additionally, the logic chip 403 inputs/outputs data DQ to and from the memory chip 402. The signal /CE is a chip enable signal. The signal /OE is an output enable signal. The signal /WE is a write enable signal. The signal /UB is an upper-byte enable signal. The signal /LB is a lower-byte enable signal. The signals A0 to A22 configure a 23-bit address signal.

Fig. 18 is a table representing an example of an electric-fuse operation code outputted from the memory controller 405 in the logic chip 403 to the memory chip 402.

The code number "0", which is a code for Address Strobe Mode Entry, makes all the address signals A0 to A22 "0". The code is a code for instructing the start of introduction of the address signals to the address register 204 in Fig. 30.

The code number "1", which is a code for Address Strobe Mode Exit (EXIT), makes the address signals A1 to A22 "0" and the address signal A0 "1". The code is a code for instructing the end of introduction of the address signals to the address register 204 in Fig. 30.

The code number "2", which is a code for Write eFuse Mode Entry, makes the address signals A0 and A2 to A22 "0" and the address signal A1 "1". The code is a code for instructing the start of writing, at and after time instant t1 in Fig. 31, in the electric fuses.

The code number "3", which is a code for Write eFuse Mode Exit (EXIT), makes the address signals A2 to A22 "0" and the address signals A0 and A1 "1". The code is a code for instructing the end of writing in the electric fuses.

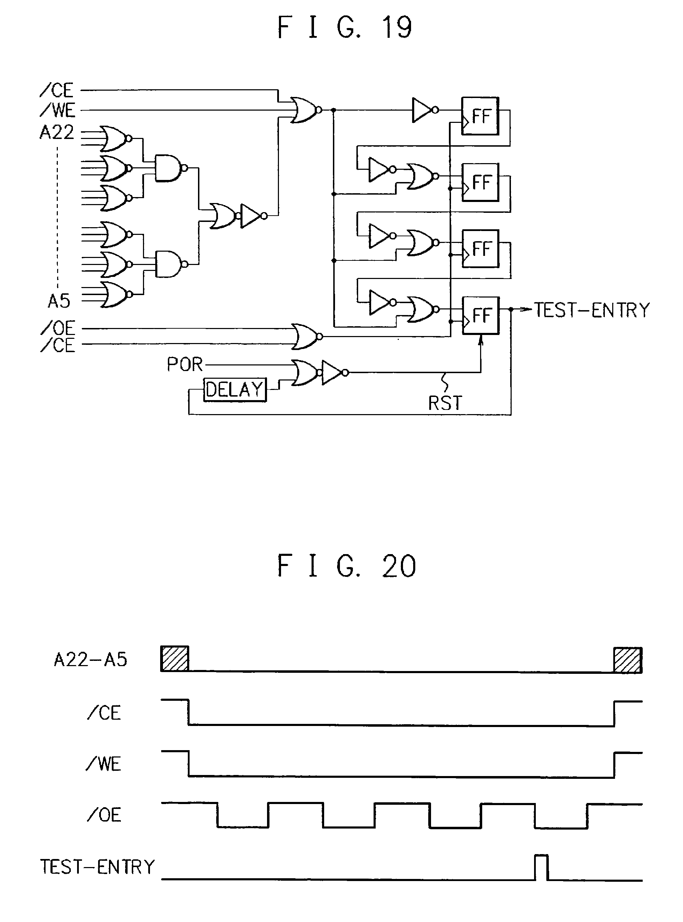

Fig. 19 is a diagram illustrating an exemplary configuration of the electric fuse control circuit 202 (in Fig. 30) for inputting the electric-fuse operation code in Fig. 18; Fig. 20 is a timing chart representing an example of the operation of the electric fuse control circuit 202. The electric fuse control circuit 202 is provided in the memory chip 402. When the electric-fuse operation code is inputted, the address signals A5 to A22, the chip enable signal /CE, and the write enable signal /WE are made "0", low-level, and low-level, respectively, and four pulses are inputted as the output enable signal /OE. The power-on-reset signal POR is a signal that has a high-level pulse at the time when the power is turned on. The reset signal RST is caused by the power-on-reset signal POR to reset four flip-flops (FFs). The final-stage flip-flop is caused by the four pulses in the output enable signal /OE to output a high-level pulse as a signal TEST-ENTRY.

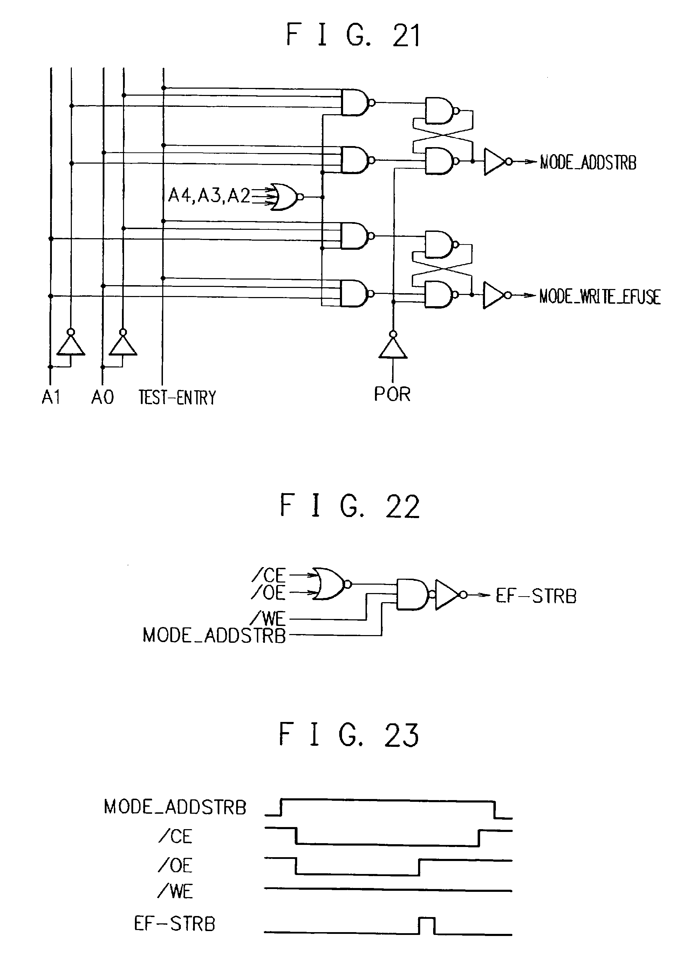

Fig. 21 is a circuit diagram illustrating an exemplary configuration of the electric fuse control circuit 202 (in Fig. 30) connected to the circuit in Fig. 19. When the signal TEST-ENTRY becomes high-level and the address signals A2 to A4 become "0", the electric fuse control circuit 202 operates as follows: when the address signals A0 and A1 are "0", the code number in Fig. 18 becomes "0" and a signal MODE_ADDSTRB becomes high-level. When the address signals A0 and A1 are "1" and "0", respectively, the code number in Fig. 18 becomes "1" and the signal MODE_ADDSTRB becomes low-level. When the address signals A0 and A1 are "0" and "1", respectively, the code number in Fig. 18 becomes "2" and a signal MODE_WRITE_EFUSE becomes high-level. When the address signals A0 and A1 are "1", the code number in Fig. 18 becomes "3" and the signal MODE_WRITE_EFUSE becomes low-level. In addition, when the power source is turned on, the power-on-reset signal POR resets the signals MODE_ADDSTRB and MODE_WRITE_ EFUSE to the low level.

Fig. 22 is a circuit diagram illustrating an exemplary configuration of the electric fuse control circuit 202 (in Fig. 30) connected to the circuit in Fig. 21; Fig. 23 is a timing chart representing an example of the operation of the electric fuse control circuit 202. The signal MODE_ADDSTRB is inputted from the circuit in Fig. 21. When the MODE_ADDSTRB is high-level, by making the chip enable signal /CE and the write enable signal /WE low-level and high-level, respectively, and making the level of the output enable signal /OE change from low to high, a high-level pulse is generated as the signal EF-STRB. That signal EF-STRB is the signal EF-STRB in Fig. 30.

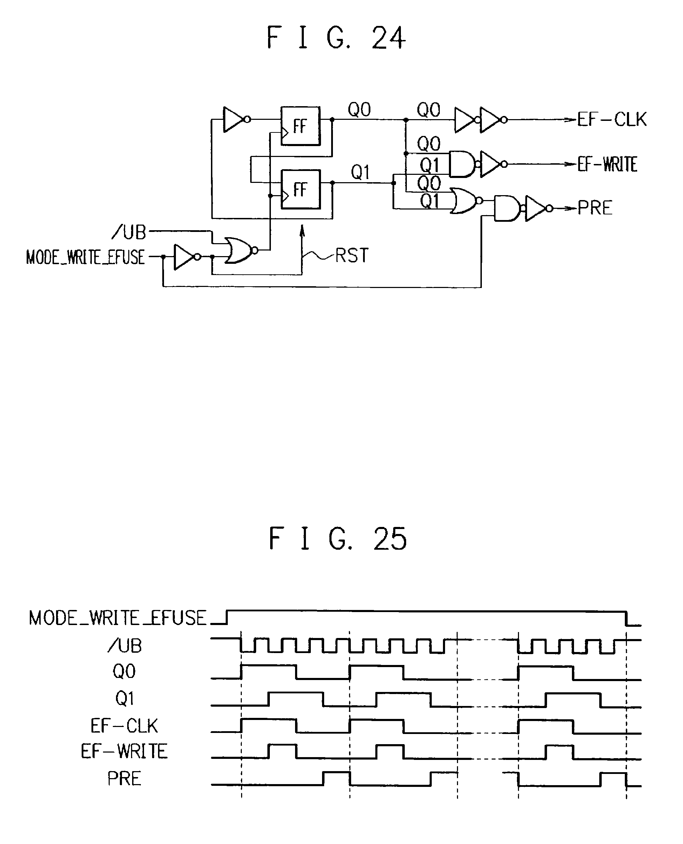

Fig. 24 is a circuit diagram illustrating an exemplary configuration of the electric fuse control circuit 202 (in Fig. 30) connected to the circuit in Fig. 21; Fig. 25 is a timing chart representing an example of the operation of the electric fuse control circuit 202. The signal MODE_WRITE_EFUSE is inputted from the circuit in Fig. 21. When the signal MODE_ WRITE_EFUSE is high-level, a constant-period pulse is inputted as the upper-byte enable signal /UB. Nodes Q0 and Q1 indicate the respective output-node voltages of two flip-flops. The electric fuse control circuit 202 generates the clock signal EF-CLK, the write signal EF-WRITE, and a precharge signal PRE. The clock signal EF-CLK and the write signal EF-WRITE are the clock signal EF-CLK and the write signal EF-WRITE in Figs. 30 and 31.

Fig. 26 is a flowchart representing an example of processing in which the memory controller 405 in the logic chip 403 in Fig. 16 performs the writing in the electric fuse circuit 404 in the memory chip 402.

At step S1401, the memory controller 405 instructs the electric fuse control circuit 202 in the memory chip 402 to perform Address Strobe Mode Entry, i.e., the code number "0" in Fig. 18. Specifically, the memory controller 405 outputs the signals illustrated in Fig. 20 to the electric fuse control circuit 202.

Next, at step S1402, the memory controller 405 outputs the signals illustrated in Fig. 23 to the electric fuse control circuit 202. Then, the electric fuse control circuit 202 introduces the address signal and the valid signal to the address register 204.

Next, at step S1403, the memory controller 405 instructs the electric fuse control circuit 202 in the memory chip 402 to perform Address Strobe Mode Exit, i.e., the code number "1" in Fig. 18. Specifically, the memory controller 405 outputs the signals illustrated in Fig. 20 to the electric fuse control circuit 202. Then, the electric fuse control circuit 202 ends the introduction processing.

Next, at step S1404, the memory controller 405 instructs the electric fuse control circuit 202 in the memory chip 402 to perform Write eFuse Mode Entry, i.e., the code number "2" in Fig. 18. Specifically, the memory controller 405 outputs the signals illustrated in Fig. 20 to the electric fuse control circuit 202.

Next, at step S1405, the memory controller 405 performs clocking of the upper-byte enable signal /UB illustrated in Fig. 25 and then outputs the clocking upper-byte enable signal /UB to the electric fuse control circuit 202. Then, the electric fuse control circuit 202 performs the writing processing in the electric fuse circuit 215.

Next, at step S1406, the memory controller 405 instructs the electric fuse control circuit 202 in the memory chip 402 to perform Write eFuse Mode Exit, i.e., the code number "3" in Fig. 18. Specifically, the memory controller 405 outputs the signals illustrated in Fig. 20 to the electric fuse control circuit 202. Then, the electric fuse control circuit 202 ends the writing processing.

As described above, the present embodiment has, as illustrated in Fig. 16, the semiconductor memory chip 402 containing the electric fuse 404, the semiconductor chip 403 different from the semiconductor memory chip 402, and the package 401 for packaging both the semiconductor memory chip 402 and the semiconductor chip 403. As illustrated in Fig. 27, the semiconductor memory chip 402 has the electric fuse circuit 1501, the normal memory cell array 1503 including a plurality of memory cells, and the redundant memory cell array 1504 including memory cells for replacing memory cells in the normal memory cell array 1503. The electric fuse circuit 1501 stores the address of a memory cell, in the normal memory cell array 1503, which is to be replaced. The semiconductor chip 403 has the memory controller 405 for controlling the write operation applied to the capacitor 101 in the electric fuse circuit 404 contained in the semiconductor memory chip 402. Additionally, each of the electric fuse circuits described in Embodiments 1 to 13 can be applied to the electric fuse circuit 1501.

As described above, according to Embodiments 1 to 14, the reliability of a semiconductor integrated circuit, which contains electric fuses, and an electronic component, which is obtained by packaging that semiconductor integrated circuit, can be enhanced. Moreover, the effect of improving the yield of an SIP obtained by mounting a semiconductor memory chip and another semiconductor chip in the same package can be demonstrated; therefore, a high-reliability inexpensive small-sized electronic component can be provided.

Additionally, the foregoing embodiments are nothing but what describes only examples of reductions to practice in which the present invention is implemented; thus, the technical scope of the present invention should not be construed in a limited fashion. In other words, the present invention can be implemented in various forms, without departing from the technical idea or the principal feature thereof.

Providing at least two transistors connected in series can reduce the electric-potential difference between the gate and the drain, and therefore a GIDL current can be prevented and the write operation for a capacitor can be properly performed.

Even when writing causes variation in the resistance values of the first and second capacitors, appropriate data corresponding to the resistance of the first and second capacitors can be read; thus, the reliability can be enhanced.

In the case where both the semiconductor memory chip and the semiconductor chip are packaged, the yield can be improved, whereby the cost can be reduced.

**Claims**

1. An electric fuse circuit comprising:

   - a first capacitor (101) and a second capacitor (101) for at least two electric fuses; and
   - an output circuit (702) outputting one-bit data, based on resistance of the first and second capacitors,
   - wherein, if resistance is small in either the first capacitor or the second capacitor, the output circuit (702) outputs a signal (EFA) indicating that the resistance is small.

2. The electric fuse circuit according to claim 1, further comprising

   - a first write circuit (103) breaking an insulating film of the first capacitor (101), by applying a voltage to a terminal of the first capacitor in response to a first write signal (WRT <A>); and
   - a second write circuit (103) for breaking an insulating film of the second capacitor (101), by applying a voltage to a terminal of the second capacitor in response to a second write signal (WRT <B>),
   - wherein the first and second write circuits apply the respective voltages to the first and second capacitors, at the different time instants.

3. The electric fuse circuit according to claim 1, wherein the output circuit has a single detection circuit commonly detecting the voltage corresponding to the resistance value of the first capacitor and the voltage corresponding to the resistance value of the second capacitor.

4. The electric fuse circuit according to claim 1, wherein the output circuit has a first detection circuit (702A) detecting the voltage corresponding to the resistance value of the first capacitor (101) and a second detection circuit (702B) detecting the voltage corresponding to the resistance value of the second capacitor.

5. The electric fuse circuit according to claim 2, further comprising

   - at least two transistors, including a first transistor (121) and a second transistor (102), which are connected in series between the first capacitor (101) and the first write circuit (103); and
   - at least two transistors, including a third transistor (121) and a fourth transistor (102), which are connected in series between the second capacitor (101) and the second write circuit (103).

# F I G. 1

# F I G. 2

F I G. 3

EP 2 105 933 A1

# F I G. 4

# F I G. 5

17

# F I G. 6

# F I G. 7

# F I G. 8

# F I G. 9

# F I G. 10

# F I G. 11

EP 2 105 933 A1

# FIG. 12

24

F I G. 13

F I G. 14

EP 2 105 933 A1

FIG. 15

F I G. 16

# F I G. 17

# F I G. 18

| Code Number | Function | A22-A5 | A4 | A3 | A2 | A1 | A0 |
|---|---|---|---|---|---|---|---|
| 0 | Address Strobe Mode Entry | 0 | 0 | 0 | 0 | 0 | 0 |
| 1 | Address Strobe Mode Exit | 0 | 0 | 0 | 0 | 0 | 1 |
| 2 | Write eFuse Mode Entry | 0 | 0 | 0 | 0 | 1 | 0 |
| 3 | Write eFuse Mode Exit | 0 | 0 | 0 | 0 | 1 | 1 |

# F I G. 19

# F I G. 20

F I G. 21

A4,A3,A2

A1    A0    TEST-ENTRY

POR

MODE_ADDSTRB

MODE_WRITE_EFUSE

F I G. 22

/CE
/OE
/WE
MODE_ADDSTRB

EF-STRB

F I G. 23

MODE_ADDSTRB
/CE
/OE
/WE
EF-STRB

# F I G. 24

# F I G. 25

# F I G. 26

| | |
|---|---|
| Address Strobe Mode Entry | ~S1401 |
| Address Strobe Operation | ~S1402 |
| Address Strobe Mode Exit | ~S1403 |
| Write eFuse Mode Entry | ~S1404 |
| Write eFuse /UB Clocking | ~S1405 |
| Write eFuse Mode Exit | ~S1406 |

# F I G. 27

~1503

Address

eFuse — 1501

Address Compare — 1502

Normal Memory Cell — 1503

Redundant Memory Cell — 1504

DQ

# F I G. 28

# F I G. 29

F I G. 30

# F I G. 31

# F I G. 32

Europäisches
Patentamt

European
Patent Office

Office européen
des brevets

## EUROPEAN SEARCH REPORT

Application Number

EP 09 16 5920

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2006/152272 A1 (SUEOKA ATSUSHI [JP]) 13 July 2006 (2006-07-13) * figure 14 * | 1-5 | INV. G11C17/16 G11C17/18 |
| Y | US 2004/205428 A1 (NANBA YASUHIRO [JP] ET AL) 14 October 2004 (2004-10-14) * figure 2 * | 1-5 | |
| A | US 6 693 481 B1 (ZHENG BO [US]) 17 February 2004 (2004-02-17) * column 6, line 18 - line 28; figure 1B * | 1 | |

TECHNICAL FIELDS
SEARCHED        (IPC)

G11C

The present search report has been drawn up for all claims

| Place of search | Date of completion of the search | Examiner |
|---|---|---|
| Munich | 5 August 2009 | Ramcke, Ties |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

                                            
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 09 16 5920

This annex lists the patent family members relating to the patent documents cited in the above-mentioned European search report.
The members are as contained in the European Patent Office EDP file on
The European Patent Office is in no way liable for these particulars which are merely given for the purpose of information.

05-08-2009

| Patent document cited in search report | | | Publication date | Patent family member(s) | | | Publication date |
|---|---|---|---|---|---|---|---|
| US 2006152272 | A1 | | 13-07-2006 | CN<br>JP<br>JP | 1815736<br>3923982<br>2006197124 | A<br>B2<br>A | 09-08-2006<br>06-06-2007<br>27-07-2006 |
| US 2004205428 | A1 | | 14-10-2004 | CN<br>JP<br>JP<br>TW | 1542849<br>4152241<br>2004296051<br>236021 | A<br>B2<br>A<br>B | 03-11-2004<br>17-09-2008<br>21-10-2004<br>11-07-2005 |
| US 6693481 | B1 | | 17-02-2004 | NONE | | | |

For more details about this annex : see Official Journal of the European Patent Office, No. 12/82

**EP 2 105 933 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002197889 A
- JP 2001338495 A